Europäisches Patentamt

(19) European Patent Office

Office européen des brevets

(11) Numéro de publication: **0 279 137 B1**

(12) **FASCICULE DE BREVET EUROPEEN**

(45) Date de publication de fascicule du brevet:
16.10.91

(51) Int. Cl.⁵: **H03H 7/06**

(21) Numéro de dépôt: 87402968.9

(22) Date de dépôt: 22.12.87

(54) **Filtre dissipatif passe-bas.**

(30) Priorité: 28.01.87 FR 8701178

(43) Date de publication de la demande:
24.08.88 Bulletin 88/34

(45) Mention de la délivrance du brevet:
16.10.91 Bulletin 91/42

(84) Etats contractants désignés:
CH DE GB IT LI SE

(56) Documents cités:
GB-A- 2 101 425

G.E. OWEN et al.: "Fundamentals of Electronics", vol. 1, pages 167,174, Harper & Row, New York, US

NUCLEAR INSTRUMENTS AND METHODS, vol. 50, 1967, pages 343-345, North-Holland Publishing Co., Amsterdam, NL; R.J. HELMER et al.: "Simplified passive element arc supply for the duo-plasmatron ion source"

ARCHIV FÜR ELEKTRONIK UND ÜBERTRA-GUNGSTECHNIK, vol. 31, no. 2, février 1977, pages 77-80, Stuttgart, DE; J.-P. BECKER et al.: "Abstimmbare Tiefpassfilter in Streifenleitungstechnik"

IEEE TRANSACTIONS ON MAGNETICS, vol. MAG-7, no. 3, septembre 1971, pages 584-585, New York, US; J.J. BIESS et al.: "Two-stage filter with nondissipatively controlled damping"

(73) Titulaire: MERLIN GERIN
Rue Henri Tarze
F-38050 Grenoble Cédex(FR)

(72) Inventeur: Broyde, Frédéric
Merlin Gerin Sce. Brevets
F-38050 Grenoble Cédex(FR)

(74) Mandataire: Kern, Paul et al
Merlin Gerin Sce. Brevets 20, rue Henri Tarze
F-38050 Grenoble Cédex(FR)

## Description

L'invention concerne un filtre dissipatif passe-bas, plus particulièrement pour le filtrage des lignes d'alimentation.

On sait que les filtres passe-bas non dissipatifs classiques, s'ils donnent satisfaction lorsque les impédances de source et de charge sont fixes, en général 50 Ohms ne sont pas adaptés au filtrage des lignes d'alimentation dans lesquelles l'impédance aux fréquences élevées n'est pas connue et peut varier.

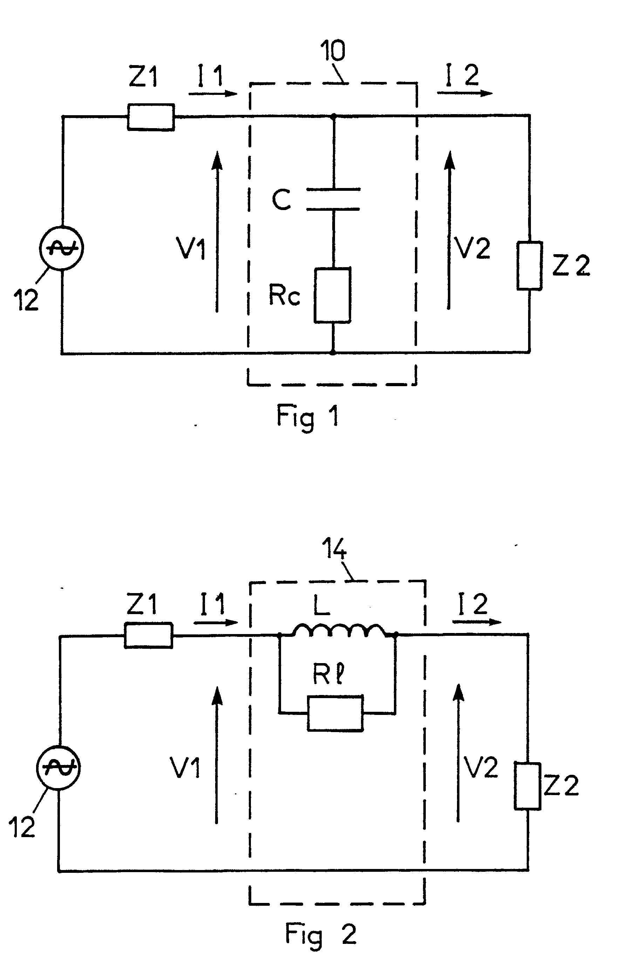

On a déjà proposé de remplacer, dans ce cas, les filtres non dissipatifs par des filtres dissipatifs ou par des filtres actifs, complexes. Les filtres dissipatifs connus sont des filtres introduisant des pertes dans l'une des branches du filtre. L'introduction de pertes dans la branche inductive série du filtre, que ce soit par utilisation de l'effet de peau ou par une dispersion dans le matériau magnétique formant la self s'est révélée inefficace pour des fréquences inférieures à 5 MHz. L'introduction d'une résistance en parallèle sur la self (voir par exemple GB-A2101425) ou d'une résistance en série avec le condensateur ne permettent pas non plus de s'affranchir des impédances de charge ou de source, ainsi que cela sera explicité plus en détail en référence aux figures 1 et 2.

L'invention a pour but un filtre dissipatif passe-bas, de type passif, utilisant des moyens très simples et permettant de garantir une atténuation minimale prédéterminée, indépendante des impédances de source et de charge, pour des fréquences élevées vis à vis de la fréquence de coupure du filtre.

A titre d'exemple, un filtre selon l'invention, destiné à laisser passer la fréquence (50 ou 60 Hz) du secteur permet d'obtenir cette atténuation minimale prédéterminée, par exemple au moins 10 dB, pour des fréquences supérieures à 10 kHz.

Le filtre selon l'invention comportant une première branche série, disposée entre une première entrée et une première sortie et constituée par une self en parallèle avec une première résistance, et une seconde branche parallèle, disposée entre la première sortie et une seconde sortie, elle-même connectée à une seconde entrée, et constituée par un condensateur disposé en série avec une seconde résistance, est caractérisé en ce que les valeurs de l'inductance L de la self, de la capacité C du condensateur et des résistances Rl et Rc respectivement en parallèle avec la self et en série avec le condensateur sont choisies de manière à ce que l'atténuation minimale M du filtre, donnée par la relation

$$M = -10 \log_{10} \left[ 1 - 2\frac{Rl}{Rc} \left( \sqrt{1 + \frac{Rc}{Rl}} - 1 \right) \right],$$

soit fixée à une valeur prédéterminée et que, pour une fréquence correspondant à une pulsation $\omega o$, au-dessus de laquelle le filtre doit présenter ladite atténuation minimale, on ait

$$Rc \gg \frac{1}{\omega_o C} \quad \text{et} \quad Rl \ll \omega_o L,$$

les valeurs de L et C définissant par ailleurs les caractéristiques du filtre à l'intérieur de la bande passante.

D'autres avantages et caractéristiques de l'invention ressortiront plus clairement de l'exposé qui va suivre d'un mode de réalisation de l'invention donné à titre d'exemple non limitatif et représenté aux dessins annexés dans lesquels :

- la figure 1 représente un premier type de filtre dissipatif passe-bas,
- la figure 2 représente un second type de filtre dissipatif passe-bas,
- la figure 3 représente un filtre dissipatif passe-bas selon l'invention,
- la figure 4 représente un filtre dissipatif passe-bas utilisant les principes de la présente invention.

Le filtre dissipatif passe-bas 10, représenté sur la figure 1 est constitué par une branche parallèle RC, constituée par un condensateur C en série avec une résistance Rc, disposée en parallèle avec l'impédance de charge Z2. On a représenté par Z1 l'impédance de source, reliée en série avec la source de tension alternative 12.

Si V1 est la tension à l'entrée du filtre, V2 la tension à la sortie du filtre, I1 et I2 respectivement les courants d'entrée et de sortie du filtre, les puissances actives P1 à l'entrée et P2 à la sortie du filtre sont respectivement données par :

$$P1 = \text{Re} (V1 \overline{I1}) \quad (1)$$

2

$P2 = Re (V2 \overline{I2})$   (2)

On désignera par R1 la partie réelle de Z1 : $R1 = Re (Z1)$, et par R2 la partie réelle de Z2 : $R2 = Re (Z2)$.

On désignera par X1 la partie imaginaire de Z1 : $X1 = Im(Z1)$, et par X2 la partie imaginaire de Z2 : $X2 = Im(Z2)$.

On peut montrer que pour des fréquences élevées par rapport à la fréquence de coupure du filtre, lorsque $Rc \gg 1/\omega C$, le rapport entre la puissance de sortie et la puissance d'entrée est donné par :

$$\frac{P2}{P1} \leq \frac{Rc}{Rc + R2} \qquad (3)$$

On a aussi :

$$\frac{Rc}{Rc + R2} \cdot R2 \leq R3 \leq Rc \text{ et } 0 \leq |X3| \leq Inf\left(\frac{Rc^2}{2(Rc+R2)} , \frac{|X2| Rc^2}{(Rc+R2)^2}\right) \qquad (4)$$

dans lequel R3 et X3 sont les parties réelle et imaginaire de Z3, impédance d'entrée du filtre vue par le générateur, soit : $Z3 = V1/I1$.

Si l'impédance de charge Z2 peut prendre n'importe quelle valeur ayant une partie réelle (R2) positive, c'est-à-dire n'importe quelle valeur physiquement possible, on voit que pour des fréquences élevées le rapport P2/P1 peut atteindre la valeur 1.

De la même façon, on peut montrer que le rapport P2/P1 peut atteindre la valeur 1, si Z2 peut prendre n'importe quelle valeur ayant une partie réelle (R2) positive pour des fréquences supérieures à la fréquence de coupure, lorsque $Rl \ll \omega L$, dans le cas du filtre dissipatif passe-bas 14 représenté sur la figure 2, constitué par une branche série RL, comportant une inductance L en parallèle avec une résistance Rl, disposée en série avec l'impédance de charge Z2. Dans ce cas, on a en effet

$$\frac{P2}{P1} = \frac{R2}{Rl + R2} \qquad (5)$$

et $R3 = Rl + R2$ et $X3 = X2$   (6)

Dans ce filtre si R2 est très grand devant Rl, P2 est voisin de P1.

Ainsi, dans les deux circonstances évoquées ci-dessus, c'est-à-dire lorsque R2 est nul pour le filtre de la figure 1 et lorsque R2 est très grand par rapport à Rl pour le filtre de la figure 2, les filtres proposés présentent une perte d'insertion nulle. L'emploi de tels filtres ne permet donc pas de résoudre le problème rencontré dans le cas de filtres non dissipatifs.

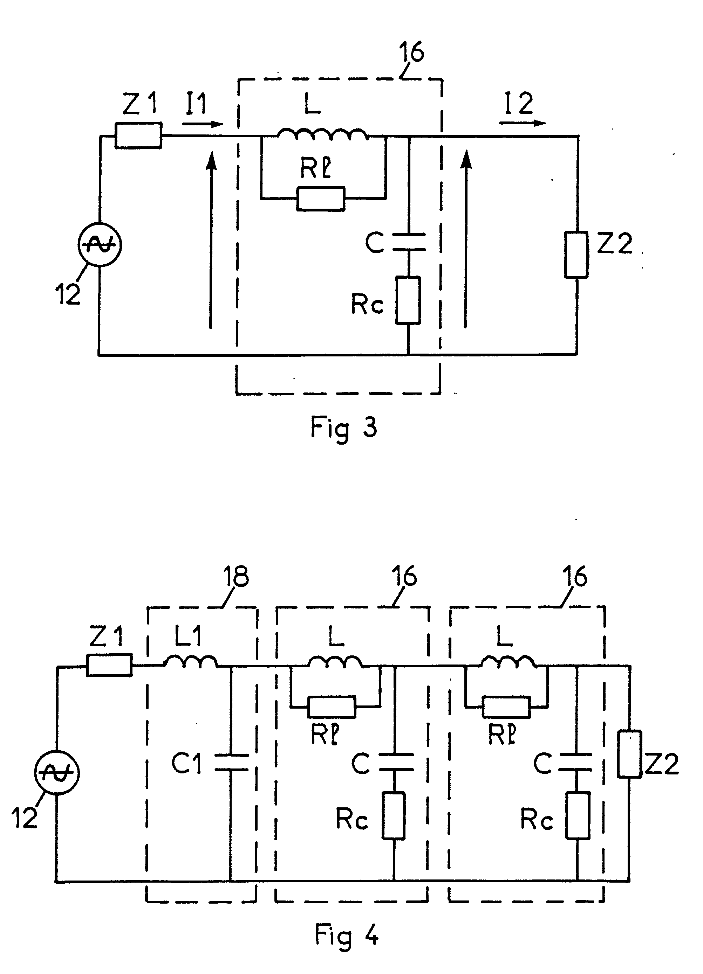

La figure 3 représente un filtre dissipatif passe-bas 16 selon l'invention. Ce filtre comporte, en combinaison, une branche série RL et une branche parallèle RC. On peut montrer que pour des fréquences élevées, pour lesquelles $Rc \gg 1/\omega C$ et $Rl \ll \omega L$, on obtient :

$$\frac{P2}{P1} \leq 1 - 2 \frac{Rl}{Rc} \left(\sqrt{1 + \frac{Rc}{Rl}} - 1\right) \qquad (7)$$

Ainsi, non seulement le rapport P2/P1 a une valeur maximale inférieure strictement à 1, mais cette valeur maximale est indépendante de l'impédance de charge et ne dépend que des valeurs respectives de Rc et Rl. Elle peut donc être fixée lors de la fabrication du filtre.

Simultanément, lorsque $Rc \gg 1/\omega C$ et $Rl \ll \omega L$, la partie réelle R3 et la partie imaginaire X3 de l'impédance Z3 d'entrée du filtre vérifient les équations suivantes :

3

$$R1 \leq R1 + \frac{Rc \; R1}{Rc+R1} \leq R3 \leq R1 + Rc \qquad (8)$$

$$et \; 0 \leq |X3| \leq Inf \left( \frac{Rc^2}{2(Rc+R2)}, \; \frac{|X2| \; Rc^2}{(Rc+R2)^2} \right) \leq \frac{Rc}{2} \qquad (9)$$

L'atténuation minimale du filtre M est donnée par :

$$M = -10 \log_{10} \left[ 1 - 2 \frac{R1}{Rc} \left( \sqrt{1 + \frac{Rc}{R1}} - 1 \right) \right] \qquad (10)$$

Si R1/Rc $\gg$ 1, ce qui est souhaitable, on obtient :

$$M \simeq 10 \log_{10} \left( 4 \frac{R1}{Rc} \right) \qquad (11)$$

On peut ainsi déterminer à l'avance l'atténuation minimale du filtre à une fréquence élevée, en choisissant les valeurs de Rl et Rc.

Par exemple, pour une atténuation minimale de 16 dB, on aura 4 Rl/Rc = 40, soit Rl/Rc = 10.

A titre d'exemple, un filtre a été réalisé avec les valeurs suivantes :

L = 1 mH,

C = 5 $\mu$F

Rl = 39 Ohms

Rc = 3,9 Ohms

Il est à noter que dans la bande passante, pour des fréquences suffisamment basses pour que RC $\ll 1/\omega C$ et Rl $\gg \omega L$, les pertes dans le filtre deviennent négligeables et les équations 7 à 10 ne sont plus applicables; les caractéristiques du filtre sont de nouveau définies par les éléments réactifs L et C.

Les valeurs de L, C, Rl et Rc sont calculées de manière à fixer une atténuation M minimale selon l'équation (10), à satisfaire aux équations Rl $\ll \omega L$ et Rc $\gg 1/\omega C$ pour une fréquence minimale prédéterminée (10 kHz par exemple) à partir de laquelle on souhaite observer le comportement du filtre selon l'équation (10), et à déterminer les caractéristiques du filtre à l'intérieur de la bande passante. On obtient donc ainsi, pour un filtre passe-bas destiné à laisser passer la fréquence du réseau (50 Hz ou 60 Hz), une atténuation minimale prédéterminée, indépendante des impédances de source et de charge, à des fréquences élevées, en pratique au-dessus de 10 kHz.

Les valeurs typiques de M pouvant être obtenues avec un filtre 16 tel que décrit sur la figure 3 sont comprises entre 10 et 30 dB. Pour obtenir des atténuations plus importantes, on disposera plusieurs filtres en cascade, comme représenté sur la figure 4.

On peut également, comme représenté sur la figure 4, utiliser en combinaison un ou plusieurs filtres dissipatifs 16 selon l'invention en cascade avec un filtre non dissipatif 18. Ce dernier, comportant une branche série L1 et une branche parallèle C1 est, par exemple, disposé entre la source à filtrer et un premier filtre dissipatif 16. Les filtres 16 servent alors à figer l'impédance de charge vue par le filtre non-dissipatif 18 qui peut ainsi être utilisé quelle que soit l'impédance de charge Z2.

On a réalisé un filtre tel que représenté sur la figure 4, dans lequel Rl = 39 Ohms et Rc = 3,9 Ohms.

On peut montrer que pour des fréquences élevées, soit lorsque : 39 Ohms $\ll \omega L$ et 3,9 Ohms $\gg 1/\omega C$, l'atténuation du dernier filtre 16 est au moins de 16 dB, d'après la formule (11). On peut également démontrer que l'atténuation des deux filtres dissipatifs 16 en cascade est au moins de 36 dB.

Par ailleurs d'après les formules (8) et (9), la partie réelle de l'impédance d'entrée du dernier filtre 16 est comprise entre 39 Ohms et 43 Ohms, tandis que la partie imaginaire de cette impédance est comprise entre -2 Ohms et 2 Ohms. La partie réelle de l'impédance d'entrée du filtre 16 intermédiaire est alors comprise entre 42,6 Ohms et 43 Ohms, la partie imaginaire de cette impédance étant comprise entre -0,017 Ohms et 0,017 Ohms. Or, cette dernière impédance constitue l'impédance de charge du filtre non-dissipatif 18 qui voit donc une impédance d'environ 43 Ohms, quelle que soit l'impédance de charge Z2. Le filtre non dissipatif 18 pourra alors être calculé de façon classique en tenant compte de cette impédance de charge.

La perte d'insertion d'un filtre dissipatif 16 étant, pour des fréquences élevées, indépendante des impédances de source et de charge, un tel filtre est moins avantageux qu'un filtre non dissipatif lorsque la charge et la source ont des impédances de 50 Ohms, ce dernier pouvant dans ces conditions fournir une atténuation bien supérieure à celle du filtre dissipatif. Il est donc intéressant de combiner les deux types de filtres dans un même filtre, comme représenté sur la figure 4, le filtre dissipatif 16 servant d'adaptateur d'impédance au filtre non-dissipatif 18 qui peut être réalisé de manière à fournir une atténuation supérieure à celle du filtre dissipatif 16, aux fréquences élevées.

Le filtre selon l'invention peut être utilisé pour le filtrage des lignes d'alimentation électrique. Il pourra, par exemple, être utilisé comme filtre d'entrée ou de sortie d'un appareil électronique de puissance, en particulier d'un dispositif d'alimentation sans coupure. Dans le cas où le filtre est utilisé pour empêcher le retour de parasites en provenance d'une alimentation sans coupure dans le réseau d'alimentation, on sait que les problèmes de filtrage se posent dans une gamme allant de 10 kHz à 30 MHz, et plus particulièrement entre 10 kHz et 200 kHz. Le filtre selon l'invention, placé à l'entrée de l'alimentation sans coupure, permet de garantir une atténuation minimale dans toute cette gamme de fréquence.

## Revendications

1. Filtre dissipatif passe-bas comportant une première branche série, disposée entre une première entrée et une première sortie et constituée par une self (L) en parallèle avec une première résistance (Rl) et une seconde branche parallèle, disposée entre la première sortie et une seconde sortie, elle-même connectée à une seconde entrée, et constituée par un condensateur (C) disposé en série avec une seconde résistance (Rc), caractérisé en ce que les valeurs de l'inductance L de la self, de la capacité C du condensateur et des résistances Rl et Rc respectivement en parallèle avec la self et en série avec le condensateur sont choisies de manière à ce que l'atténuation minimale M du filtre, donnée par la relation

$$M = -10 \log_{10} \left[ 1-2 \frac{Rl}{Rc} \left( \sqrt{1 + \frac{Rc}{Rl}} - 1 \right) \right]$$

soit fixée à une valeur prédéterminée, et que, pour une fréquence, correspondant à une pulsation $\omega_o$, au-dessus de laquelle le filtre doit présenter ladite atténuation minimale, on ait

$$Rc \gg \frac{1}{\omega_o C} \quad \text{et} \quad Rl \ll \omega_o L,$$

les valeurs de L et C définissant par ailleurs les caractéristiques du filtre à l'intérieur de la bande passante.

2. Filtre dissipatif passe-bas, caractérisé en ce qu'il comporte plusieurs filtres (16) selon la revendication 1 en cascade.

3. Filtre dissipatif passe-bas, caractérisé en ce qu'il comporte un filtre passe-bas non-dissipatif (18) disposé en cascade avec au moins un filtre dissipatif passe-bas (16) selon la revendication 1.

## Claims

1. A dissipative low-pass filter comprising a first series branch, located between a first input and a first output and formed by an inductance coil (L) in parallel with a first resistor (Rl) and a second parallel branch, located between the first output and a second output, itself connected to a second input, and formed by a capacitor (C) disposed in series with a second resistor (Rc), characterized in that the values of the inductance coil (L), of the capacitor (C) and of the resistors (Rl) and (Rc) respectively in parallel with the inductance coil and in series with the capacitor are chosen in such a way that the minimum attenuation M of the filter, given by the relation

$$M = -10 \log_{10} \left[ 1-2 \frac{R1}{Rc} \left( \sqrt{1 + \frac{Rc}{R1}} - 1 \right) \right]$$

is fixed at a predetermined value, and that, for an angular frequency $\omega$ o, above which the filter must present said minimum attenuation, we have

$$Rc \gg \frac{1}{\omega oC} \quad \text{and R1} \ll \omega oL,$$

the values of L and C moreover defining the characteristics of the filter inside the pass band.

2. A dissipative low-pass filter, characterized in that it comprises cascading of several filters (16) according to claim 1.

3. A dissipative low-pass filter, characterized in that it comprises a non-dissipative low-pass filter (18) fitted in cascading with at least one dissipative low-pass filter (16) according to claim 1.

**Patentansprüche**

1. Dissipativer Tiefpassfilter mit einem zwischen einem ersten Eingang und einem zweiten Ausgang geschalteten Serienleitungsstück, das durch eine parallel zu einem ersten Widerstand (R1) geschaltete Induktionsspule (L) gebildet wird, und mit einem zweiten parallelen zwischen dem ersten Ausgang und einem zweiten Ausgang geschalteten Leitungsstück, welches selbst an einem zweiten Eingang verbunden ist und durch einen in Serie mit einem zweiten Widerstand (Rc) geschalteten Kondensator (C) gebildet wird, dadurch gekennzeichnet, dass die Werte der Induktion L der Spule, der Kapazität C des Kondensators und der bzw. parallel mit der Spule und in Serie mit dem Kondensator liegenden Widerstände R1 und Rc so gewählt sind, dass die durch die Gleichung

$$M = -10 \log_{10} \left[ 1-2 \frac{R1}{Rc} \left( \sqrt{1 + \frac{Rc}{R1}} - 1 \right) \right]$$

gegebene Mindestabdämpfung M des Filters auf einen vorbestimmten Wert festgesetzt ist, und dass, für eine bestimmte Frequenz, die einer Pulsierung $\omega$ o entspricht, über welcher der Filter die genannte Mindestabdämpfung aufweisen muss, man hat

$$Rc \gg \frac{1}{\omega oC} \quad \text{and R1} \ll \omega oL,$$

wobei die Werte von L und C die Kennzeichen des Filters innerhalb des Durchlassbereiches bestimmen.

2. Dissipativer Tiefpassfilter, dadurch gekennzeichnet, dass er mehrere Filter (16) gemäss Anspruch 1 in Kaskade aufweist.

3. Dissipativer Tiefpassfilter, dadurch gekennzeichnet, dass er einen nicht-dissipativen Tiefpassfilter (18) in Kaskade mit wenigstens einem dissipativen Tiefpassfilter (16) gemäss Anspruch 1 aufweist.

Z1   I1   10   I2

C

V1   V2   Z2

Rc

12

Fig 1

14

Z1   I1   L   I2

Rℓ

V1   V2   Z2

12

Fig 2

Fig 3

Fig 4